# EUROPÄISCHE PATENTSCHRIFT

(11) **EP 0 590 336 B1**
(45) Veröffentlichungstag und Bekanntmachung des Hinweises auf die Patenterteilung: **05.03.1997**
(21) Anmeldenummer: 93114017.2
(22) Anmeldetag: 02.09.1993
(51) Int. Cl.: H01L 33/00, H01L 31/0232, H01S 3/025

(54) **Optoelektronisches Bauelement mit engem Öffnungswinkel**
Optoelectronic element with narrow beam angle
Elément optoélectronique avec un faisceau à faible divergence angulaire

(30) Priorität: 02.10.1992 DE 4233125; 07.04.1993 DE 4311530
(43) Veröffentlichungstag der Anmeldung: 06.04.1994
(73) Patentinhaber: TEMIC TELEFUNKEN microelectronic GmbH, 74072 Heilbronn (DE)
(72) Erfinder: Schairer, Werner, Dr., D-74189 Weinsberg (DE); Riedel, Jürgen, D-75050 Gemmingen (DE); Angerstein, Jörg, Dr., D-74223 Flein (DE); Mistele, Thomas, D-74360 Ilsfeld (DE); Giebler, Siegfried, D-71543 Wüstenrot (DE)
(74) Vertreter: Maute, Hans-Jürgen, Dipl.-Ing.

(56) Entgegenhaltungen:
- EP-A- 0 364 806
- CA-A- 917 812
- JP-A- 1 230 274
- JP-A- 1 232 775
- JP-A- 1 241 184
- JP-A- 1 273 367
- JP-A- 2 130 876
- JP-A- 2 280 388
- JP-A- 3 288 478

## Beschreibung

Die Erfindung betrifft ein optoelektronisches Bauelement mit einem engen Öffnungswinkel nach dem Oberbegriff des Anspruchs 1. Weiterhin betrifft die Erfindung ein Verfahren zum Herstellen eines solchen Bauelements.

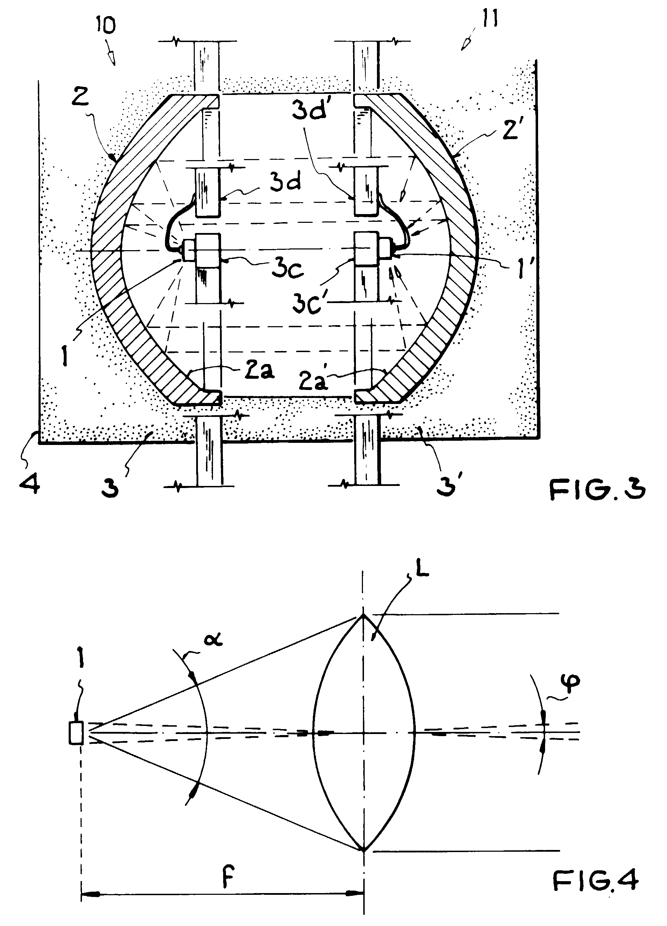

Konventionelle optoelektronische Halbleiterbauelemente, wie z. B. Leuchtdioden, weisen zur Einengung des Öffnungswinkels einschalige Linsen aus Plastik auf. Derartige Bauelemente sind z. B. in Gillessen, Schairer, "Light emitting diodes: an introduction", Prentice-Hall International, 1987, S. 217 - 219, Fig. 7-6 beschrieben. Diese konventionellen Bauteile weisen den Nachteil auf, daß eine Einengung des Abstrahlwinkels Ø mit der Vergrößerung der Brennweite f einhergeht. Gleichzeitig werden die Bauteilabmessungen in Abstrahlrichtung größer. Damit ursächlich verknüpft ist, daß bei vorgegebenem Linsen- und damit im allgemeinen auch Bauteildurchmesser der Aperturwinkel α kleiner wird und gleichzeitig, im Falle eines Optoemitters, die Nutzleistung zurückgeht. Im Falle eines Detektors reduziert sich die Menge der einfallenden Lichtleistung. Der allgemeine Zusammenhang zwischen dem Abstrahlwinkel Ø des Bauelements, der Brennweite f der Linse und dem Aperturwinkel α bei den bekannten Bauelementen ist in der Figur 4 dargestellt.

Aus der EP-A-0 364 806 ist ein optoelektronisches Bauelement bekannt, bei dem flächenhaft verteilte Lumineszenz-Halbleiterkörper durch eine Leitbahnstruktur miteinander verbunden und die einzelnen Lumineszenz-Halbleiterkörper von Gehäusekörper umgeben sind. Der Gehäusekörper entsteht durch einen Verguß mit einer transparenten Kunststoff-Vergußmasse. Die Gehäusekörper weisen eine parabolische Form auf, deren Außenflächen zur Bildung eines Reflektors mit einem hochreflektierenden Material beschichtet werden. Die Halbleiterkörper sind derart angordnet, daß sie jeweils im Brennpunkt eines Reflektors liegen.

Aufgabe der Erfindung ist es daher, ein optoelektronisches Bauelement anzugeben, das einen engen Abstrahlwinkel aufweist, sich gleichzeitig durch geringe Bautiefe und hohe Leistungsausbeute auszeichnet und auf einfache Art herzustellen ist.

Diese Aufgabe wird durch ein Bauelement mit den kennzeichnenden Merkmalen des Anspruchs 1 gelöst.

Es ist eine weitere Aufgabe der Erfindung, ein Verfahren anzugeben, nach dem das erfindungsgemäße Bauelement herzustellen ist.

Diese Aufgabe wird durch ein Verfahren mit den kennzeichnenden Merkmalen des Anspruchs 6 gelöst.

Vorteilhafte Ausgestaltungen des Bauelements und des Verfahrens zum Herstellen des Bauelements ergeben sich aus den unteransprüchen.

Insbesondere kann gemäß Anspruch 7 das erfindungsgemäße optoelektronische Bauelement zum Aufbau eines Optokopplers verwendet werden. Hierzu wird ein Optoemitter und ein Optodetektor gemäß der Erfindung einander gegenübergestellt und über ein Gehäuse optisch und mechanisch gekoppelt.

Bei einer solchen Anordnung befinden sich der Emitter- und Detektorchip in einem Faraday'schen Käfig, der durch den metallischen Montagestreifen und den metallischen Reflektor gebildet wird. Folglich befindet sich jeder der beiden Chips in einem nahezu feldfreien Raum, unabhängig von der anliegenden Spannung.

Dies führt bei einem solchen Optokoppler zu einer wesentlichen Verbesserung der langfristigen Spannungsfestigkeit. Denn die über einen langen Zeitraum anliegende Gleichspannung bedeutet eine starke Belastung der Chips, insbesondere des Detektorchips. Die Belastung ist um so größer, je höher die Spannung, je höher die Temperatur und je länger die Zeit ist, während welcher alle Änderungen der Funktionsdaten unterhalb einer vorgegebenen Grenze bleiben sollen.

Die genannte Belastung kommt dadurch zustande, daß auf Ladungen in den Passivierungsschichten unter dem Einfluß der durch die Spannung bestimmten Feldstärke eine Kraft wirkt. Falls es zur Bewegung von Ladungen kommt, reichern sich diese an den Grenzflächen der Passivierung an. Es kann zu Verarmungsschichten oder sogar Inversionsschichten im angrenzenden Siliziummaterial kommen, die die Funktionsdaten des Chips verändern können.

Zu entsprechenden Effekten kann es selbst im Falle stabiler Passivierungsschichten durch den die Chips einbettenden Kunststoff kommen. Enthält der Kunststoff Ladungen, so werden auch diese zur Wanderung tendieren, sich gegebenenfalls an der Oberfläche der Halbleiterchips anreichern und je nach der Auslegung dieser Chips zu mehr oder weniger großen Änderungen der Meßdaten führen.

Da die Chips des oben beschriebenen Optokopplers, der mit den erfindungsgemäßen optoelektronischen Bauelementen aufgebaut ist, in einem nahezu feldfreien Raum liegen, werden von diesen die oben beschriebenen Belastungen ferngehalten. Insbesondere bei Hochspannungskopplern, bei denen Spannungsspitzenwerte von mehr als 5 kVₛₛ auftreten können, wird das durch diese Spannung hervorgerufene Feld abgeschirmt.

Eine solche Lösung ist gegenüber bekannten Optokopplern billig und von wesentlich höherer Wirksamkeit. Ferner ist vorteilhaft, daß bei einem solchen Optokoppler sehr kleine Empfängerchips einsetzbar sind und der Abstand des Optoemitters und des Optodetektors ohne großen Einfluß auf den Koppelfaktor infolge des engen Öffnungswinkels der Bauelemente vergrößerbar ist. Schließlich ergibt sich trotz des großen Abstandes eine relativ kurze Baulänge des Optokopplers.

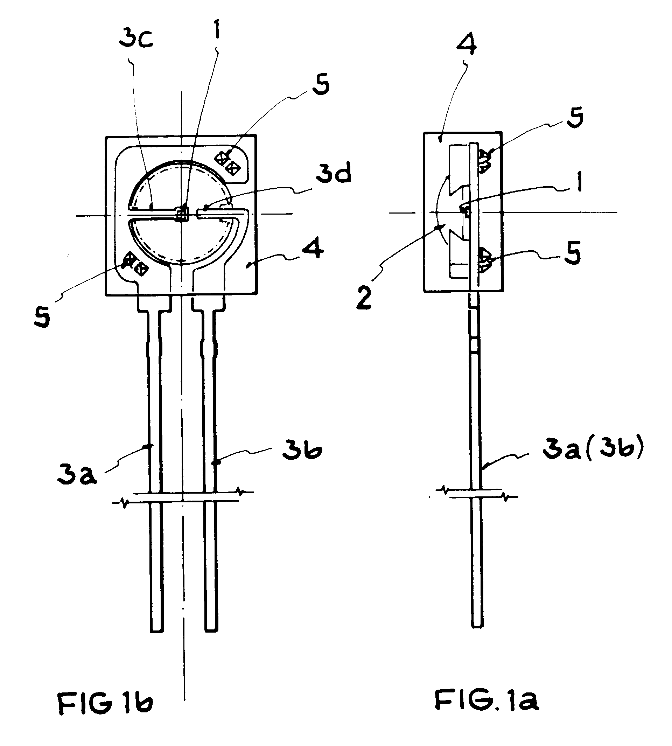

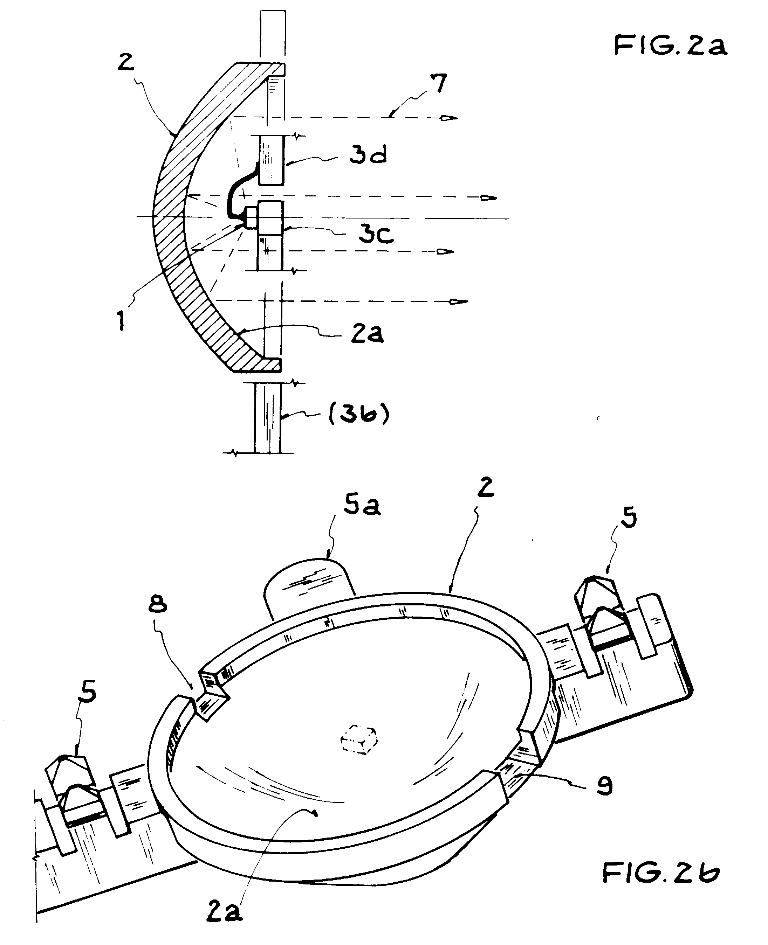

Die Erfindung sei im nachfolgenden anhand der Figuren 1 und 2 erläutert. Dabei zeigt die
- Figur 1a: die Seitenansicht einer vorteilhaften Ausführung des Bauelements,
- Figur 1b: die Vorderansicht der in Figur 1a dargestellten Ausführung,
- Figur 2: die genaue Form des Reflektors,
- Figur 3: eine Seitenansicht eines mit erfindungsgemäßen optoelektronischen Bauelementen aufgebauten Optokopplers.

Das in Figur 1 dargestellte Bauelement besteht aus einem optoelektronischen Halbleiterchip 1, der entweder ein auf Strahlung ansprechender Empfänger oder ein Strahlung aussendender Emitter sein kann. Für beide Ausführungsformen, Optoemitter und Optodetektor, gilt nachfolgendes in äquivalenter Weise. Bei den Betrachtungen sind lediglich der Lichtweg 7 umzukehren bzw. abgestrahlte und detektierte Strahlungsleistungen auszutauschen, etc.

Der Halbleiterchip 1 ist auf einem Trägerstreifen 3 aufmontiert. Der Trägerstreifen 3 besteht im Ausführungsbeispiel aus zwei im wesentlichen parallelen Schenkeln 3a, 3b. Im oberen Bereich weist der Schenkel 3a eine Abzweigung 3c auf, die in Richtung des anderen Schenkels weist. Die Abzweigung 3c des einen Schenkels reicht etwas weiter als bis zur Symmetrieachse des Reflektors. Der Halbleiterchip ist am freien Ende dieser Abzweigung 3c im Zentrum des Reflektors angebracht und mit beiden Teilen des Trägerstreifens elektrisch verbunden. Dies erfolgt vorteilhaft einerseits anhand des Rückseitenkontakts für den Teilstreifen 3c, auf dem der Halbleiterchip 1 montiert ist. Der elektrische Anschluß zum anderen Teilstreifen 3d erfolgt mittels eines Bonddrahtes. Es ist natürlich auch möglich, beide Anschlüsse mit Bonddrähten zu kontaktieren, insbesondere dann, wenn die beiden elektrischen Anschlüsse des Halbleiterchips 1 auf dessen Oberseite angeordnet sind. Des weiteren ist es möglich, den Streifen 3d bis ins Zentrum des Reflektors zu führen und dort den Chip zu montieren.

Zum Zeitpunkt der Montage des Halbleiterchips und des Reflektors sind die Zuleitungen 3a, 3b der beiden Teilstreifen mit Stegen verbunden. Erst nachdem das Bauteil vergossen ist, werden die Enden freigeschnitten, wodurch zwei separate Anschlüsse entstehen.

Auf den Trägerstreifen 3 ist ein Reflektor 2 derart angebracht, daß das Halbleiterchip 1 möglichst im Brennpunkt des parabolischen Reflektors 2 liegt. Der Reflektor 2 weist gemäß der Erfindung Rastelemente 5 auf, in die der Trägerstreifen fest eingerastet ist.

Die gesamte Anordnung ist von einem Gehäuse 4 umgeben, wobei ein Teil des Trägerstreifens 3a, 3b aus dem Gehäuse 4 herausragt und als Anschluß- und Montagebeinchen für das Bauelement dient. Das Gehäuse 4 besteht vorteilhaft aus einem lichtdurchlässigen Kunststoff und wird beispielsweise durch Vergießen der Anordnung mit einer Kunstharzmasse hergestellt.

Nachfolgend sei ein Verfahren zum Herstellen des oben beschriebenen Bauelements beschrieben. Zunächst wird mittels üblicher Verfahrensschritte der Halbleiterchip 1 und der Trägerstreifen 3 hergestellt. Der Trägerstreifen weist dabei schon die in der Figur 1 gezeigte Form auf, mit der Ausnahme, daß die beiden Teilstreifen an den beiden unteren Schenkeln 3a, 3b, die später die Anschlußbeinchen bilden, durch Stege miteinander verbunden sind. Am anderen Ende weist einer der beiden Teilstreifen eine Abzweigung 3c auf, die sich dem anderen Streifen 3d annähert. Auf den bis ins Zentrum des Reflektors ragenden Streifenteil 3c oder 3d wird der Halbleiterchip montiert. Weist der Halbleiterchip einen Rückseitenkontakt auf, erfolgt die Montage durch Verlöten oder Verkleben mit einem leitfähigen Kunststoffkleber. Bei dieser Vorgehensweise wird gleichzeitig ein elektrischer Kontakt zu dem einen Teilstreifen 3c des Trägerstreifens geschaffen. Der zweite elektrische Kontakt wird durch ein Drahtbondverfahren hergestellt. Dabei wird ein auf der Oberseite liegender Kontakt des Halbleiterchips mit dem zweiten Teilstreifen verbunden. In einer anderer Ausführung wird der Halbleiterchip auf die längere Abzweigung 3c aufgeklebt. Anschließend werden die elektrischen Kontakte des Halbleiterchips mit den Teilstreifen verbunden. Dies erfolgt zweckmäßigerweise durch ein bekanntes Drahtbondverfahren. Im nächsten Verfahrensschritt wird der Reflektor 2 mit dem Kontaktstreifen 3 verbunden, so daß der Halbleiterchip dem Reflektor zugewandt ist und möglichst in dessen Brennpunkt zu liegen kommt. Der Reflektor ist mit Rastelementen 5 ausgerüstet, und der Trägerstreifen 3 wird lediglich positionsgenau in die Rastelemente 5 eingerastet. Um das Positionieren zu erleichtern, können Positionierhilfen wie kegelförmige Spitzen der Rasthaken vorgesehen sein.

Abschließend wird die Anordnung mit einem lichtdurchlässigen Gehäuse 4 versehen. Dies erfolgt durch ein an sich bekanntes Verfahren wie z. B. das Vergießen in einer Kunstharzmasse. Die Anordnung wird vollständig vergossen. Lediglich die als Anschlußbeinchen bestimmten Enden 3a, 3b des Trägerstreifens bleiben frei. Die oben beschriebenen Verbindungsstege, die der Anordnung während der Montage die nötige Festigkeit verliehen haben, werden abschließend noch entfernt.

Das auf diese Weise hergestellte optoelektronische Bauelement weist eine geringe Abmessung in Ab- bzw. Einstrahlrichtung bei einem sehr kleinen Öffnungswinkel auf. Weiterhin wird bei dem erfindungsgemäßen Bauelement eine sehr hohe Strahlparallelität und ein sehr großer Aperturwinkel erzielt.

Die in den Figuren 1 und 2 beschriebenen erfindungsgemäßen optoelektronischen Bauelemente, die sowohl als Optoemitter als auch Optodetektor verwendbar sind, können zur Herstellung eines Optokopplers gemäß der Figur 3 verwendet werden, wo mit den Bezugszeichen 10 und 11 ein Optoemitter bzw. ein Optodetektor bezeichnet sind. Die einzelnen Teile dieser Bauelemente sind mit den entsprechenden Bezugszeichen aus den Figuren 1 und 2 bezeichnet, wobei diejenigen Bezugszeichen des Optoemitters 10 ungestrichen und diejenigen Bezugszeichen des Optodetektors 11 gestrichen sind. Anhand der Figur 3 ist nun ersichtlich, daß jeder Chip, also der Emitterchip 1 als auch der Detektorchip 1' in einem Faraday'schen Käfig liegt, der aus dem Reflektor 2 bzw. 2' und dem Trägerstreifen 3 bzw. 3' gebildet ist. Dabei ist jeweils die Oberfläche 2a bzw. 2a' des Reflektors 2 bzw. 2' metallisiert, die jeweils mit einem Teil 3a oder 3b bzw. 3a' oder 3b' des zugehörigen Trägerstreifens 3 bzw. 3' elektrisch leitend verbunden ist, um die Wirkung eines Faraday'schen Käfigs sicherzustellen. Somit kann das von der zwischen der Empfänger- und Senderseite liegenden Trennspannung erzeugte elektrische Feld abgeschirmt werden, so daß langfristig eine hohe Spannungsfestigkeit sichergestellt ist.

Dadurch, daß die jeweiligen Chips 1 und 1' im Brennpunkt der Reflektoren 1 und 1' liegen, wird die von dem Emitterchip 1 abgegebene Strahlung 7 nahezu vollständig auf den Detektorchip 1' fokussiert, womit es möglich ist, sehr kleine Empfängerchips einzusetzen, was zu einer Kostenreduzierung bei der Herstellung des Optokopplers führt. Auf die gleiche Ursache ist auch der Vorteil zurückzuführen, daß der Abstand zwischen den beiden Bauelementen 10 und 11 ohne großen Einfluß auf den Koppelfaktor vergrößerbar ist.

## Patentansprüche

1. Optoelektronisches Bauelement mit einem engen Öffnungswinkel bestehend aus einem Strahlung aussendenden oder auf Strahlung ansprechenden Halbleiterchip (1), der auf einem Trägerstreifen (3) montiert ist, wobei ein parabolischer oder näherungsweise parabolischer Reflektor (2) vorgesehen ist, der mit dem Trägerstreifen (3) derart verbunden ist, daß der auf dem Trägerstreifen (3) montierte Halbleiterchip (1) möglichst im Brennpunkt der parabolischen oder näherungsweise parabolischen Oberfläche (2a) des Reflektors (2) liegt, dadurch gekennzeichnet, daß der Reflektor (2) Rastelemente (5) aufweist, in die der Trägerstreifen (3) eingerastet ist.

2. Optoelektronisches Bauelement nach Anspruch 1, dadurch gekennzeichnet, daß der Halbleiterchip (1) auf der dem Reflektor (2) zugewandten Seite des Trägerstreifens (3) montiert ist.

3. Optoelektronisches Bauelement nach Anspruch 1 oder 2, dadurch gekennzeichnet, daß der Reflektor (2) aus einem Kunststoff besteht, wobei wenigstens eine Oberfläche mit einem hochreflektierenden Metall beschichtet ist.

4. Optoelektronisches Bauelement nach einem der Ansprüche 1 bis 3, dadurch gekennzeichnet, daß der Reflektor (2), der Halbleiterchip (1) und Teile des Trägerstreifens (3) vollständig von einem lichtdurchlässigen Gehäuse (4) umgeben sind und daß ausschließlich die als Anschlußbeinchen (3a, 3b) dienenden Enden des Trägerstreifens (3) aus dem Gehäuse herausragen.

5. Optoelektronisches Bauelement nach einem der Ansprüche 1 bis 4, dadurch gekennzeichnet, daß der Trägerstreifen (3) zwei Teilstreifen (3a, 3b) aufweist und daß nur einer der beiden Teilstreifen (3a oder 3b) mit dem Reflektor (2) Kontakt hat.

6. Verfahren zum Herstellen eines optoelektronischen Bauelements mit einem engen Öffnungswinkel, in dessen Verlauf ein Halbleiterchip (1) auf einem Trägerstreifen (3) montiert wird und elektrische Kontakte zwischen Halbleiterchip (1) und Trägerstreifen (3) hergestellt werden, wobei ein Reflektor (2) derart angeordnet ist, daß der Halbleiterchip (1) dem Reflektor (2) zugewandt ist und im wesentlichen in dessen Brennpunkt liegt, dadurch gekennzeichnet, daß der Reflektor (2) Rastelemente (5) aufweist, daß vor dem Ausbilden eines Gehäuses (4) der Reflektor mit dem Trägerstreifen (3) verbunden wird in dem der Trägerstreifen (3) beim Montieren in die Rastelemente eingerastet wird.

7. Verwendung des optoelektronischen Bauelementes nach einem der Ansprüche 1 bis 5 zur Herstellung eines aus einem Optoemitter (10) und einem Optodetektor (11) aufgebauten Optokopplers, wobei der Reflektor (2, 2') sowohl des Optoemitters (10) als auch des Optodetektors (11) eine Metallisierung aufweist und diese Metallisierung jedes Reflektors (2, 2') jeweils mit einem der beiden Teile (3a, 3b; 3a', 3b') des zugehörigen, den Emitterchip (1) bzw. den Detektorchip (1') tragenden Trägerstreifens (3, 3') elektrisch leitend verbunden ist.

## Claims

1. An optoelectronic component with a narrow opening angle comprising a semiconductor chip (1) which transmits radiation or responds to radiation and which is mounted on a carrier strip (3), where a parabolic or approximately parabolic reflector (20 is provided which is connected to the carrier strip (3) in such manner that the semiconductor chip (1) mounted on the carrier strip (3) is situated as far as possible at the focal point of the parabolic or approximately parabolic surface (2a) of the reflector (2), characterised in that the reflector (2) comprises locking elements (5) into which the carrier strip (3) is engaged.

2. An optoelectronic component according to Claim 1, characterised in that the semiconductor chip (1) is mounted on that side of the carrier strip (3) which faces towards the reflector (2).

3. An optoelectronic component according to Claim 1 or 2, characterised in that the reflector (2) is composed of a plastics material, where at least one surface is coated with a highly reflective metal.

4. An optoelectronic component according to one of Claims 1 to 3, characterised in that the reflector (2), the semiconductor chip (1) and parts of the carrier strip (3) are completely surrounded by a light-transmissive housing (4) and that only those ends of the carrier strip (3) which serve as terminal legs (3a, 3b) project from the housing.

5. An optoelectronic component according to one of Claims 1 to 4, characterised in that the carrier strip (3) comprises two sub-strips (3a, 3b) and that only one of the two sub-strips (3a or 3b) is in contact with the reflector (2).

6. A process for the production of an optoelectronic component with a narrow opening angle, in the course of which a semiconductor chip (1) is mounted on a carrier strip (3) and electric contacts are established between the semiconductor chip (1) and the carrier strip (3), where a reflector (2) is arranged in such manner that the semiconductor chip (1) faces towards the reflector (2) and is situated substantially at the focal point thereof, characterised in that the reflector (2) comprises locking elements (5), and that prior to the construction of a housing (4) the reflector is connected to the carrier strip in that upon assembly the carrier strip (3) is engaged into the locking elements.

7. The use of the optoelectronic component according to one of Claims 1 to 5 for the production of an opto-coupler constructed from an opto-emitter (10) and an opto-detector (11), where the reflector (2, 2') both of the opto-emitter (10) and of the opto-detector (11) comprises a metallisation and the said metallisation of each reflector (2, 2') is in each case electrically conductively connected to one of the two parts (3a, 3b; 3a', 3b') of the associated carrier strip (3, 3') which bears the emitter chip (1) or the detector chip (1').

## Revendications

1. Composant opto-électronique à faible angle d'ouverture se composant d'une puce semiconductrice (1) émettant un rayonnement ou recevant un rayonnement, qui est montée sur une bande support (3), un réflecteur parabolique ou approximativement parabolique (2) étant prévu, qui est relié à la bande support (3) de telle sorte que la puce semiconductrice (1) montée sur la bande support (3) se trouve le plus possible au foyer de la surface parabolique ou approximativement parabolique (2a) du réflecteur (2), caractérisé en ce que le réflecteur (2) présente des éléments d'arrêt (5), dans lesquels est encastrée la bande support (3).

2. Composant opto-électronique selon la revendication 1, caractérisé en ce que la puce semiconductrice (1) est montée sur le côté de la bande support (3) tourné vers le réflecteur (2).

3. Composant opto-électronique selon la revendication 1 ou 2, caractérisé en ce que le réflecteur (2) est en une matière plastique, au moins une surface étant revêtue d'un métal hautement réfléchissant.

4. Composant opto-électronique selon l'une des revendications 1 à 3, caractérisé en ce que le réflecteur (2), la puce semiconductrice (1) et les éléments de la bande support (3) sont complètement entourés par un boîtier (4) transparent et en ce qu'exclusivement, les extrémités de la bande support (3) servant de broches de raccordement (3a, 3b) font saillie du boîtier.

5. Composant opto-électronique selon l'une des revendications 1 à 4, caractérisé en ce que la bande support (3) comporte deux bandes partielles (3a, 3b) et en ce que seulement une des deux bandes partielles (3a, ou 3b) se trouve en contact avec le réflecteur (2).

6. Procédé de fabrication d'un composant opto-électronique à angle d'ouverture faible, selon lequel est montée une puce semiconductrice (1) sur une bande support (3) et des contacts électriques sont établis entre la puce semiconductrice (1) et la bande support (3), un réflecteur (2) étant disposé de telle sorte que la puce semiconductrice (1) est tournée vers le réflecteur (2) et se trouve sensiblement au foyer de celui-ci, caractérisé en ce que le réflecteur (2) présente des éléments d'arrêt (5), en ce qu'avant la formation d'un boîtier (4), le réflecteur est relié à la bande support (3) dans lequel la bande support (3) est encastrée dans les éléments d'arrêt.

7. Utilisation du composant opto-électronique selon l'une des revendications 1 à 5 en vue de la fabrication d'un coupleur optique se composant d'un émetteur optique (10) et d'un détecteur optique (11), le réflecteur (2, 2') non seulement de l'émetteur optique (10), mais également du détecteur optique (11) présentant une métallisation, et cette métallisation de chaque réflecteur (2, 2') est reliée de façon électriquement conductrice à l'une des deux parties (3a, 3b; 3a', 3b') de la bande support (3, 3') associée supportant la puce émettrice (1) ou la puce détectrice (1').
